# EUROPEAN PATENT SPECIFICATION

(11) **EP 3 507 794 B1**
(45) Date of publication and mention of the grant of the patent: **09.12.2020**
(21) Application number: 17845543.2
(22) Date of filing: 31.08.2017
(51) Int. Cl.: G10K 9/122, H01L 41/083, G01V 1/02, G10K 9/125, B06B 1/06, H04R 17/00, H04R 1/44

(54) **PIEZOELECTRIC ACTUATOR AND LOW FREQUENCY UNDERWATER PROJECTOR**
PIEZOELEKTRISCHER AKTUATOR UND NIEDERFREQUENZ-UNTERWASSERPROJEKTOR
ACTIONNEUR PIÉZOÉLECTRIQUE ET PROJECTEUR SOUS-MARIN BASSE FRÉQUENCE

(30) Priority: 31.08.2016 CN 201610798548
(43) Date of publication of application: 10.07.2019
(73) Proprietor: Beijing Supersonic Technology Co., Ltd., Beijing 100192 (CN)
(72) Inventor: WANG, Penghui, Beijing 100192 (CN); LIU, Guoxi, Beijing 100192 (CN); WANG, Zhipeng, Beijing 100192 (CN); SHI, Huaduo, Beijing 100192 (CN)
(74) Representative: Tiburzi, Andrea
(86) International application number: PCT/CN2017/100095
(87) International publication number: WO 2018/041241

(56) References cited:
- WO-A1-01/50811
- CN-A- 102 071 927
- CN-A- 102 136 268
- CN-A- 102 136 268
- CN-A- 103 646 642
- CN-A- 104 811 879
- CN-A- 106 205 583
- CN-U- 206 134 236
- US-A- 5 508 976
- US-A- 5 508 976

## Description

### FIELD OF THE INVENTION

The present invention relates to the field of acoustic sensors, and in particular to a piezoelectric actuator and a low frequency underwater projector.

### BACKGROUND OF THE INVENTION

Currently, the use of sound waves as an information carrier is relatively effective means of underwater communication, and an underwater projector is an indispensable key part for underwater communication. With the rapid development of modern sonar technology and the continuous increase of application requirements, the low frequency, light weight and miniaturization of the underwater projector has become an important trend of its development. The low frequency underwater projectors currently widely used include magneto-strictive low frequency underwater transducers, flextensional transducers and modified products thereof, flexural transducers, and so on. CN102136268A discloses a bent piezoelectric ceramic low-frequency underwater projector.

However, although most of the existing low frequency underwater acoustic transducers can be miniaturized, a piezoelectric material in the low frequency underwater acoustic transducer often has a small axial displacement, leading to a limited sound power capacity of the transducer.

### SUMMARY OF THE INVENTION

In view of this, embodiments of the present invention provide a piezoelectric actuator and a low frequency underwater projector to improve the problem of the limited sound power capacity of the existing low frequency underwater projectors.

To achieve the above object, an embodiment of the present invention provides a piezoelectric actuator according to appended claim 1. The piezoelectric actuator includes a first level connector, a second level connector disposed opposite to the first level connector, a set first of piezoelectric material columns, a set of second piezoelectric material columns, and a set of third piezoelectric material columns. A surface of the first level connector that is opposite to the second level connector is provided with a set of first recesses, a surface of the second level connector that is opposite to the first level connector is provided with a set of second recesses corresponding to the first recesses, and the number of the first recesses and the number of the second recesses are each equal to the number of the first piezoelectric material columns; the set of first piezoelectric material columns and the first level connector are connected in a way that the first piezoelectric material columns are matched with the first recesses; and the set of first piezoelectric material columns and the second level connector are connected in a way that the first piezoelectric material columns are matched with the second recesses.

The surface of the first level connector that is opposite to the second level connector is provided with a set of first through holes running through the first level connector, the surface of the second level connector that is opposite to the first level connector is provided with a set of third recesses, and the number of the first through holes and the number of the third recesses are each equal to the number of the second piezoelectric material columns; the set of second piezoelectric material columns and the first level connector are connected in a way that the second piezoelectric material columns are inserted into the first through holes; and the set of second piezoelectric material columns and the second level connector are connected in a way that the second piezoelectric material columns are matched with the third recesses.

One end of each of the second piezoelectric material columns in the set of second piezoelectric material columns is inserted into one of the first through holes of the first level connector, and the other end of each of the second piezoelectric material column is matched with one of the third recesses of the second level connector, that is, the second piezoelectric material columns are connected with the second level connector, but the second piezoelectric material columns do not penetrate through the second level connector; and the second piezoelectric material columns are inserted into the first through holes located in the first level connector, and the second piezoelectric material columns penetrate through the first level connector.

The number of the second piezoelectric material columns is three, then the number of the first through holes located in the first level connector is also three, and the number of the third recesses located in the second level connector is likewise three.

The surface of the first level connector that is opposite to the second level connector is provided with a set of fourth recesses, the surface of the second level connector that is opposite to the first level connector is provided with a set of second through holes running through the second level connector, and the number of the fourth recesses and the number of the second through holes are each equal to the number of the third piezoelectric material columns; the set of third piezoelectric material columns and the first level connector are connected in a way that the third piezoelectric material columns are matched with the fourth recesses; and the set of third piezoelectric material columns and the second level connector are connected in a way that the third piezoelectric material columns are inserted into the second through holes.

One end of each of the third piezoelectric material columns is matched with one of the fourth recesses of the first level connector, and the other end of each of the third piezoelectric material column is inserted into one of the second through holes of the second level connector, that is, the third piezoelectric material columns are connected with the first level connector, but the third piezoelectric material columns do not penetrate through the first level connector; and the third piezoelectric material columns are inserted into the second through hole of the second level connector, and the third piezoelectric material columns penetrate through the second level connector.

The number of the third piezoelectric material columns is three, then the number of the fourth recesses of the first level connector is also three, and the number of the second through holes of the second level connector is likewise three.

Optionally, in the piezoelectric actuator described above, the first piezoelectric material columns, the second piezoelectric material columns, and the third piezoelectric material columns are all cylindrical piezoelectric material columns.

All the piezoelectric material columns described above may be cylindrical piezoelectric material columns, and it should be understood that the piezoelectric material columns may also be of other shapes such as rectangular shapes or square shapes, and the specific shape of the piezoelectric material column should not be construed as limiting the present invention.

Optionally, in the piezoelectric actuator described above, the piezoelectric material columns are each composed of a piezoelectric ceramic stack of a suitable cross-section.

The piezoelectric material columns may be each composed of a piezoelectric ceramic stack, and specifically, each piezoelectric material column may be formed by bonding an even number of piezoelectric ceramic sheets in series, and polarization directions of two adjacent piezoelectric ceramic sheets are opposite, wherein the piezoelectric ceramics include PZT piezoelectric ceramics and materials derived therefrom.

The piezoelectric material column may be formed in other ways, for example, composed of a radially polarized piezoelectric ceramic tube, and the specific way of forming the piezoelectric material column should not be construed as limiting the present invention.

Optionally, in the piezoelectric actuator described above, the set of first piezoelectric material columns, the set of second piezoelectric material columns, and the set of third piezoelectric material columns are all rectangular parallelepiped piezoelectric material columns.

The piezoelectric material columns described above may be all rectangular parallelepiped piezoelectric material columns, and it should be understood that the piezoelectric material columns may also be of other shapes such as prism, and the specific shape of the piezoelectric material column should not be construed as limiting the present invention.

Optionally, in the piezoelectric actuator described above, the rectangular parallelepiped piezoelectric material columns are all made of lead-based relaxor ferroelectric single crystal.

The lead-based relaxor ferroelectric single crystals may specifically comprise Pb(Zn_{1/3}Nb_{2/3})O₃-PbTiO₃, Pb(Mg_{1/3}Nb_{2/3})O₃-PbTiO₃, Pb(In_{1/2}Nb_{1/2})O₃-Pb(Mg_{1/3}Nb_{2/3})O₃-PbTiO₃, Pb(Mg_{1/3}Nb_{2/3})O₃-Pb(Zr₀.₄₈Ti₀.₅₂)O₃, and materials derived therefrom.

It will be appreciated that the piezoelectric material column may also be made of other material, and the specific material from which the piezoelectric material column is made should not be construed as limiting the present invention.

Optionally, in the piezoelectric actuator described above, each of the rectangular parallelepiped piezoelectric material columns comprises a first single crystal active element and a second single crystal active element, the size of the first single crystal active element is the same as that of the second single crystal active element, and the first single crystal active element and the second single crystal active element are connected by bonding.

The single crystal slices of the first single crystal active element and the second single crystal active element have a polarization direction of [011] and have a higher transverse piezoelectric coefficient in the [100] direction, wherein, the [011] direction is the polarization direction of the single crystal, and the [100] direction is a driving direction.

Optionally, in the piezoelectric actuator described above, a central mechanical preloading mechanism is further comprised, the first level connector further comprises a central through hole located in the first level connector, and the second level connector further comprises a central through hole located in the second level connector, the central mechanical preloading mechanism is inserted into the central through hole of the first level connector, and the central mechanical preloading mechanism is inserted into the central through hole of the second level connector.

The first level connector comprises a central through hole running through the first level connector, the second level connector comprises a central through hole running through the second level connector, and the position of the central through hole of the first level connector corresponds to the position of the central through hole of the second level connector. The central mechanical preloading mechanism may be inserted into the central through hole of the first level connector, and the central mechanical preloading mechanism is inserted into the central through hole of the second level connector.

The embodiment of the present invention also provides a low frequency underwater projector comprising a piezoelectric actuator according to appended claim 1 and further comprising a front radiation head and a tail mass, one end of the piezoelectric actuator is connected with the front radiation head, and the other end of the piezoelectric actuator is connected with the tail mass.

The embodiment of the present invention provides a piezoelectric actuator according to appended claim 1, that includes a first level connector, a second level connector disposed opposite to the first level connector, a set of first piezoelectric material columns, a set of second piezoelectric material columns, and a set of third piezoelectric material columns,
wherein both ends of each of the first piezoelectric material columns are connected with the first level connector and the second level connector, respectively;
wherein each of the second piezoelectric material columns has one end connected with the second level connector and the other end running through the first level connector and extending in a direction away from the second level connector, and the second piezoelectric material columns are connected with the second level connector and movably connected with the first level connector; and
wherein each of the third piezoelectric material columns has one end connected with the first level connector and the other end running through the second level connector and extending in a direction away from the first level connector, and the third piezoelectric material columns are connected with the first level connector and movably connected to the second level connector.

A surface of the first level connector that is opposite to the second level connector is provided with a set of first recesses at equal angular separation, a surface of the second level connector that is opposite to the first level connector is provided with a set of second recesses corresponding to the first recesses, and the number of the first recesses and the number of the second recesses are each equal to the number of the first piezoelectric material columns; and
the set of first piezoelectric material columns and the first level connector are connected in a way that the first piezoelectric material columns are matched with the first recesses; and the set of first piezoelectric material columns and the second level connector are connected in a way that the first piezoelectric material columns are matched with the second recesses.

The surface of the first level connector that is opposite to the second level connector is provided with a set of first through holes at equal angular separation running through the first level connector, a surface of the second level connector that is opposite to the first level connector is provided with a set of corresponding third recesses, and the number of the first through holes and the number of the third recesses are each equal to the number of the second piezoelectric material columns; and
the set of second piezoelectric material columns and the first level connector are connected in a way that the second piezoelectric material columns are inserted into the first through holes; and the set of second piezoelectric material columns and the second level connector are connected in a way that the second piezoelectric material columns are matched with the third recesses.

The surface of the first level connector that is opposite to the second level connector is provided with a set of fourth recesses at equal angular separation, a surface of the second level connector that is opposite to the first level connector is provided with a set of corresponding second through holes running through the second level connector, and the number of the fourth recesses and the number of the second through holes are each equal to the number of the third piezoelectric material columns;
the set of third piezoelectric material columns and the first level connector are connected in a way that the third piezoelectric material columns are matched with the fourth recesses; and
the set of third piezoelectric material columns and the second level connector are connected in a way that the third piezoelectric material columns are inserted into the second through holes. Optionally, the first recesses are disposed in an annular array manner, a connection line from the center of one of the first recesses to the center of the said annular array is a first connection line, and angles between any two adjacent first connection lines are the same.

For example, the number of the first recesses is three, and an angle between any adjacent first recesses is 60°, that is to say, the angle between any two adjacent first connection lines is 60°.

Optionally, the third recesses are disposed in an annular array manner, a connection line from the center of one of the third recesses to the center of the said annular array is a third connection line, and angles between any two adjacent third connection lines are the same.

The first through holes are disposed in an annular array manner, a connection line from the center of one of the first through holes to the center of the annular array is a second connection line, and angles between any two adjacent second connection lines are the same.

For example, the number of the third recesses is three, and an angle between any adjacent third recesses is 60°, that is to say, the angle between any two adjacent third connection lines is 60°.

For example, the number of the first through holes is three, and an angle between any adjacent first through holes is 60°, that is to say, the angle between any two adjacent second connection lines is 60°. Optionally, the fourth recesses are disposed in an annular array manner, a connection line from the center of one of the fourth recesses to the center of the said annular array is a fourth connection line, and angles between any two adjacent fourth connection lines are the same; and

the second through holes are disposed in an annular array manner, a connection line from the center of one of the second through holes to the center of the said annular array is a fifth connection line, and angles between any two adjacent fifth connection lines are the same.

Similarly, when each of the number of the fourth recesses and the number of the second through holes is three, an angle between two adjacent fourth recesses is 60°, and an angle between two adjacent second through holes is 60°.

Optionally, the piezoelectric actuator further comprises a first pre-stress mechanism, wherein the first pre-stress mechanism is connected with the first level connector and the second level connector, the first pre-stress mechanism is configured to apply pre-stress to the first level connector and the second level connector so that the first piezoelectric material columns are under predetermined compressive stress during operation.

Optionally, the first level connector further comprises a central through hole located in the first level connector, and the second level connector further comprises a central through hole located in the second level connector.

Optionally, the first pre-stress mechanism comprises a first stress rod, at least one first resilient member and at least one first locking member. Both ends of the first stress rod pass through the central through holes corresponding to the first level connector and the second level connector, respectively. The at least one first resilient member, between the at least one locking member and the first level connector and/or the second level connector, are pressed by the at least one locking member and the first level connector and/or the second level connector.

The embodiment of the present invention provides a low frequency underwater projector comprising the piezoelectric actuator according to appended claim 1 and further comprising a front radiation head and a tail mass, wherein the set of second piezoelectric material columns is connected with the front radiation head, and the set of third piezoelectric material columns is connected with the tail mass.

Optionally, a first pre-stress mechanism is further comprised, the first pre-stress mechanism is connected with the first level connector and the second level connector, and the first pre-stress mechanism is configured to apply pre-stress to the first level connector and the second level connector so that the first piezoelectric material columns are under predetermined compressive stress during operation.

Optionally, both the first level connector further comprises a central through hole located in the first level connector, and the second level connector further comprises a central through hole located in the second level connector; and

the first pre-stress mechanism comprises a first stress rod, at least one first resilient member and at least one first locking member, both ends of the first stress rod pass through the central through holes corresponding to the first level connector and the second level connector respectively, and the at least one first resilient members, between at least one locking member and the first level connector and/or the second level connector are pressed by the at least one locking member and the first level connector and/or the second level connector.

Optionally, a second pre-stress mechanism is further comprised, the second pre-stress mechanism is connected with the front radiation head and the tail mass, and the second pre-stress mechanism is configured to apply pre-stress to the front radiation head and the tail mass so that the second piezoelectric material columns and the third piezoelectric material columns are under predetermined compressive stress during operation.

Optionally, the second pre-stress mechanism comprises a second stress rod and at least one second resilient members; and

the first stress rod has a central through hole running along its own length direction, and the second stress rod is movably embedded in the central through hole of the first stress rod and has both ends extending beyond the central through hole; and at least one end of the second stress rod is connected with the front radiation head and/or the tail mass through the second resilient members, respectively, so as to apply the predetermined compressive stress to the second and third piezoelectric material columns in between the front radiation head and the tail mass.

Optionally, the compressive stress applied by the first pre-stress mechanism is at least 2 times the compressive stress applied by the second pre-stress mechanism.

Optionally, an anti-bending guide means is further comprised, and the guide means and the piezoelectric actuator are movably connected in a direction of extending and contraction of the piezoelectric actuator and connected in a direction perpendicular to the direction of extending and contraction.

The advantageous effects of the piezoelectric actuator and the low frequency underwater projector provided in the embodiments of the present invention are as follows:
the piezoelectric actuator and the low frequency underwater projector comprise a first level connector, a second level connector, a set of first piezoelectric material columns, a set of second piezoelectric material columns, and a set of third piezoelectric material columns. When the set of first piezoelectric material columns is contracted, the first level connector and the second level connector can be brought close to each other so that the distal ends of the set of second piezoelectric material columns and the distal ends of the set of third piezoelectric material columns are further away from each other. In an allowable electric field or voltage condition, when the set of first piezoelectric material columns is contracted and the set of second piezoelectric material columns and the set of third piezoelectric material columns extend, the net extending or contraction displacement of the piezoelectric actuator as a whole is almost equal to the sum of the displacements of the set of first piezoelectric material columns, the set of second piezoelectric material columns, and the set of third piezoelectric material columns. The axial displacements of the piezoelectric materials can be superimposed and increased by excitation at an appropriate AC voltage, thus the sound power capacity of the low frequency underwater projector using the piezoelectric actuator as a driving mechanism is increased. The piezoelectric actuator and the low frequency underwater projector provided in the embodiments of the present invention improve the problem of the limited sound power capacity of the existing low frequency underwater projectors. The piezoelectric actuator provided in the embodiments of the present invention can also be referred to as a piezoelectric enhanced actuator because its axial displacement is enhanced.

### BRIEF DESCRIPTION OF DRAWINGS

For illustrating technical solutions of embodiments of the present invention or of the prior art more clearly, drawings required for use in the description of the embodiments or the prior art will be introduced briefly below. It is apparent that the drawings in the following description are merely illustrative of some embodiments of the present invention as defined in the appended claims.
Fig. 1 is a structural schematic view of a first level connector provided in a preferred embodiment of the present invention;
Fig. 2 is a structural schematic view, from another viewing angle, of the first level connector provided in the preferred embodiment of the present invention;
Fig. 3 is a structural schematic view of a second level connector provided in a preferred embodiment of the present invention;
Fig. 4 is a structural schematic view, from another viewing angle, of the second level connector provided in the preferred embodiment of the present invention;
Fig. 5 is a schematic view showing parital structure of a piezoelectric actuator provided in a preferred embodiment of the present invention;
Fig. 6 is a structural schematic view of the piezoelectric actuator provided in the preferred embodiment of the present invention, in a specific implementation;
Fig. 7 is a simplified schematic view of an operation state of the piezoelectric actuator provided in the preferred embodiment of the present invention.
Fig. 8 is a structural schematic view of a low frequency underwater projector provided in a preferred embodiment of the present invention;
Fig. 9 is a structural schematic view, from another viewing angle, fof the low frequency underwater projector provided in the preferred embodiment of the present invention;
Fig. 10 is a structural schematic view of a piezoelectric actuator provided in another preferred embodiment of the present invention; and
Fig. 11 is a structural schematic view of a low frequency underwater projector provided in another preferred embodiment of the present invention.

Reference numerals: 100- piezoelectric actuator; 110- first level connector; 111- first recess; 112-first through hole; 113- fourth recess; 114- first base; 115- second base; 120- second level connector; 121- second recess; 122- third recess; 123- second through hole; 124- third base; 125- fourth base; 130-combination of first piezoelectric material columns;,131- first piezoelectric material column; 140-combination of second piezoelectric material columns; 141- second piezoelectric material column; 150-combination of third piezoelectric material columns; 151- third piezoelectric material column; 161-first single crystal active element; 162- second single crystal active element; 170- central mechanical preloading mechanism; 180- central through hole; 200- low frequency underwater projector; 210- front radiation head; 220- tail mass.

### DETAILED DESCRIPTION OF THE INVENTION

The technical solutions of the embodiments of the present invention will be described below clearly and completely with reference to the drawings of the embodiments of the present invention.

### Embodiments

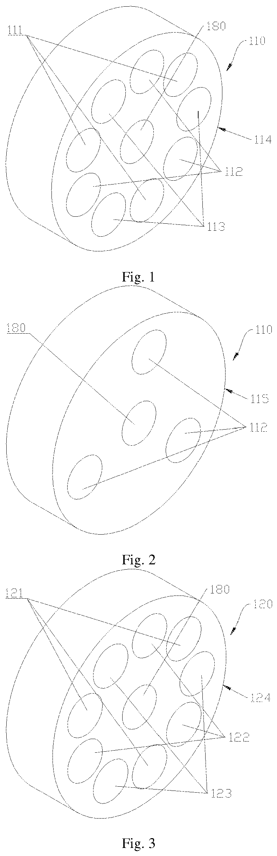

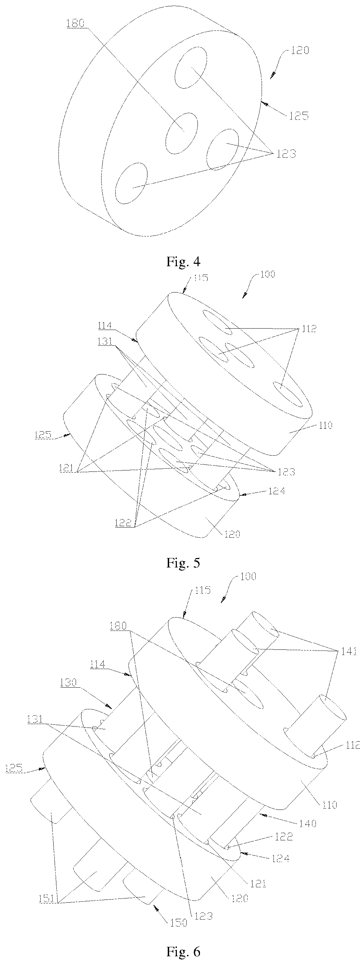

Figs. 1 and 2 show a first level connector 110 provided in a preferred embodiment of the present invention, Figs. 3 and 4 show a second level connector 120 provided in a preferred embodiment of the present invention, and Fig. 5 shows partial structure of a piezoelectric actuator 100 in a preferred embodiment of the present invention. Referring to Figs. 1 to 5 for details, the piezoelectric actuator 100 provided in the embodiment of the present invention comprises a first level connector 110, a second level connector 120, and a set of first piezoelectric material columns (combination of first piezoelectric material columns 131) 130. The set of first piezoelectric material columns 130 is connected with the first level connector 110 and the second level connector 120, respectively.

The first level connector 110 comprises a set of first recesses 111, a set of first through holes 112, a set of fourth recesses 113, and a central through hole 180, referring to Fig. 1 for details, and the set of first recesses 111, the set of first through holes 112, the set of fourth recesses 113 and the central through hole 180 are all disposed at a first base 114 of the first level connector 110. The first level connector 110 is specifically in a disc-like structure.

Each of the number of the first recesses 111, the number of the first through holes 112, and the number of the fourth recesses 113 is three, and the first recesses 111, the first through holes 112, and the fourth recesses 113 are uniformly distributed at the first base 114 of the first level connector 110, referring to Fig. 1 for details.

The first through holes 112 run through the first level connector 110, referring to Fig. 2 for details, and the first through holes 112 running through the first level connector 110 are shown in a second base 115 of the first level connector 110 as shown in Fig. 2.

The central through hole 180 is disposed at the position of a circle center of the disc-like first level connector 110, and the central through hole 180 likewise runs through the first level connector 110, referring to Fig. 2 for details.

The second level connector 120 comprises a set of second recesses 121, a set of third recesses 122, a set of second through holes 123 and a central through hole 180, referring to Fig. 3 for details, and the set of second recesses 121, the set of third recesses 122, the set of second through holes 123 and the central through hole 180 are all disposed at a third base 124 of the second level connector 120. The second level connector 120 is specifically in a disc-like structure.

Each of the number of the second recesses 121, the number of the third recesses 122, and the number of the second through holes 123 is three, and the second recesses 121, the third recesses 122, and the second through holes 123 are uniformly distributed at the third base 124 of the disc-like second level connector 120.

The second through holes 123 run through the second level connector 120, referring to Fig. 4 for details, and the second through holes 123 running through the second level connector 120 are shown in a fourth base 125 of the second level connector 120 as shown in Fig. 4.

The central through hole 180 is disposed at the position of a circle center of the disc-like second level connector 120, and the central through hole 180 likewise runs through the second level connector 120, referring to Fig. 4 for details. The set of first piezoelectric material columns 130 comprises three first piezoelectric material columns 131, referring to Fig. 5 for details.

In the partial structure of the piezoelectric actuator 100 as shown in Fig. 5, the first base 114 of the first level connector 110 is opposite to the third base 124 of the second level connector 120. The positions of the three first recesses 111 located in the first base 114 of the first level connector 110 are corresponding to the positions of the three second recesses 121 located in the third base 124 of the second level connector 120, respectively.

The positions of the three first through holes 112 located in the first level connector 110 are corresponding to the positions of the three third recesses 122 located in the third base 124 of the second level connector 120, respectively.

The positions of the three fourth recesses 113 located in the first base 114 of the first level connector 110 are corresponding to the positions of the three second through holes 123 located in the second level connector 120, respectively.

The three first piezoelectric material columns 131 are corresponding to the three first recesses 111 of the first level connector 110 respectively, that is, the set of first piezoelectric material columns 130 and the first level connector 110 are connected in a way that the first piezoelectric material columns 131 are matched with the first recesses 111. Specifically, the first piezoelectric material columns 131 are correspondingly bonded into the first recesses 111 of the first level connector 110 by means of bonding, and one ends of the first piezoelectric material columns 131 are matched with the first recesses 111 located in the first base 114 of the first level connector 110.

The three first piezoelectric material columns 131 are corresponding to the three second recesses 121 of the second level connector 120 respectively, that is, the set of first piezoelectric material columns 130 and the second level connector 120 are connected in a way that the first piezoelectric material columns 131 are matched with the second recesses 121. Specifically, the first piezoelectric material columns 131 are correspondingly bonded into the second recesses 121 of the second level connector 120 by means of bonding, the other ends of the first piezoelectric material columns 131 are matched with the second recesses 121 located in the third base 124 of the second level connector 120, and the first base 114 is opposite to the third base 124, referring to Fig. 5 for details.

The piezoelectric actuator 100 provided in the embodiment of the present invention further comprises a set of second piezoelectric material columns (combination of second piezoelectric material columns 141) 140 and a third set of piezoelectric material column (combination of third piezoelectric material columns 151) 150, referring to Fig. 6 for details.

In the piezoelectric actuator 100 shown in Fig. 6, the first base 114 of the first level connector 110 is opposite to the third base 124 of the second level connector 120. The positions of the three first recesses 111 located in the first base 114 of the first level connector 110 are corresponding to the positions of the three second recesses 121 located in the third base 124 of the second level connector 120, respectively.

The positions of the three first through holes 112 located in the first level connector 110 are corresponding to the positions of the three third recesses 122 located in the third base 124 of the second level connector 120, respectively.

The positions of the three fourth recesses 113 located in the first base 114 of the first level connector 110 are corresponding to the positions of the three second through holes 123 located in the second level connector 120, respectively.

The set of second piezoelectric material columns 140 comprises three second piezoelectric material columns 141, referring to Fig. 6 for details. The three second piezoelectric material columns 141 are corresponding to the three first through holes 112 of the first level connector 110, respectively, that is, the set of second piezoelectric material columns 140 and the first level connector 110 are connected in a way that the second piezoelectric material columns 141 are inserted into the first through holes 112. One ends of the second piezoelectric material columns 141 are inserted into the first through holes 112 located in the first level connector 110, and the second piezoelectric material columns 141 penetrate through the first level connector 110 through the first through hole 112 and extend out of the second base 115 of the first level connector 110, referring to Fig. 6 for details. The second piezoelectric material columns 141 and the first level connector 110 are connected in an insertion manner so that the second piezoelectric material columns 141 are enabled to be moved or displaced relative to the first level connector 110.

The three second piezoelectric material columns 141 are corresponding to the three third recesses 122 of the second level connector 120, respectively, that is, the set of second piezoelectric material columns 140 and the second level connector 120 are connected in a way that the second piezoelectric material columns 141 are matched with the third recesses 122. Specifically, the second piezoelectric material columns 141 are correspondingly bonded into the third recesses 122 of the second level connector 120 by means of bonding, and the other ends of the second piezoelectric material columns 141 are matched with the third recesses 122 located in the third base 124 of the second level connector 120.

The set of third piezoelectric material columns 150 comprises three third piezoelectric material columns 151, referring to Fig. 6 for details. The three third piezoelectric material columns 151 are corresponding to the three fourth recesses 113 of the first level connector 110, respectively, that is, the set of third piezoelectric material columns 150 and the first level connector 110 are connected in a way that the third piezoelectric material columns 151 are matched with the fourth recesses 113. Specifically, the third piezoelectric material columns 151 are correspondingly bonded into the fourth recesses 113 of the first level connector 110 by means of bonding, and one ends of the third piezoelectric material columns 151 are matched with the fourth recesses 113 located in the first base 114 of the first level connector 110.

The three third piezoelectric material columns 151 are corresponding to the three second through holes 123 of the second level connector 120 respectively. That is, the set of third piezoelectric material columns 150 and the second level connector 120 are connected in a way that the third piezoelectric materials 151 are inserted into the second through holes 123. The other ends of the third piezoelectric material columns 151 are inserted into the second through holes 123 located in the second level connector 120, and the third piezoelectric material columns 151 may penetrate through the second level connector 120 through the second through holes 123 and extend out of the fourth base 125 of the second level connector 120, referring to Fig. 6 for details. The third piezoelectric material columns 151 and the second level connector 120 are connected in an insertion manner so that the third piezoelectric material columns 151 are enabled to be moved or displaced relative to the second level connector 120.

The first recesses 111 are disposed in an annular array manner, a connection line from the center of one of the first recesses 111 to the center of the said annular array is a first connection line, and angles between any two adjacent first connection lines are the same. For example, the number of the first recesses 111 is three, and an angle between any adjacent first recesses 111 is 60°, that is to say, the angle between any two adjacent first connection lines is 60°.

The third recesses 122 are disposed in an annular array manner, a connection line from the center of one of the third recesses 122 to the center of the said annular array is a third connection line, and angles between any two adjacent third connection lines are the same. For example, the number of the third recesses 122 is three, and an angle between any adjacent third recesses 122 is 60°, that is to say, the angle between any two adjacent third connection lines is 60°.

The first through holes 112 are disposed in an annular array manner, a connection line from the center of one of the first through holes 112 to the center of the annular array is a second connection line, and angles between any two adjacent second connection lines are the same. For example, the number of the first through holes 112 is three, and an angle between any adjacent first through holes 112 is 60°, that is to say, the angle between any two adjacent second connection lines is 60°.

Further, in Fig. 1, each of the first recesses 111, the first through holes 112, and the fourth recesses 113 arranged along a circumferential direction in the first level connector 110 are in an alternate deposition. Similarly, each of the second recesses 121, the third recesses 122 and the second through holes 123 in the second level connector 120 are in an alternate deposition.

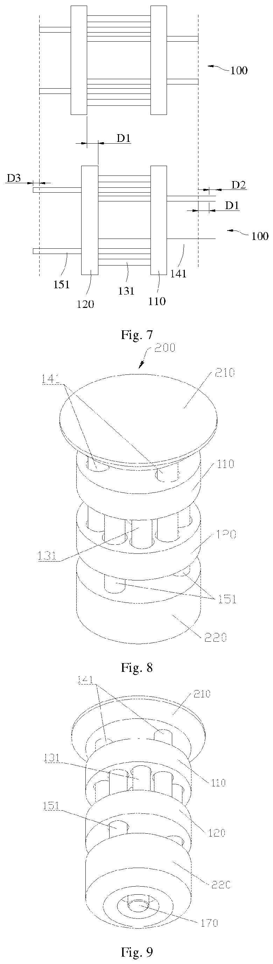

The piezoelectric actuator 100 further comprises a central mechanical preloading mechanism 170, the central through hole 180 of the first level connector 110 is opposite to the central through hole 180 of the second level connector 120, and the central mechanical preloading mechanism 170 penetrates through both the central through hole 180 of the first level connector 110 and the central through hole 180 of the second level connector 120, referring to Fig. 9 for details.

The piezoelectric actuator 100 provided in the embodiment of the present invention comprises a first level connector 110, a second level connector 120, first piezoelectric material columns 131, second piezoelectric material columns 141, third piezoelectric material columns 151, and a central mechanical preloading mechanism 170, wherein the first piezoelectric material columns 131 are connected with both the first level connector 110 and the second level connector 120 by being matched with the recesses; the second piezoelectric material columns 141 penetrate through the first level connector 110 and are connected with the second level connector by being matched with the recesses; and the third piezoelectric material columns 151 are connected with the first level connector 110 by being matched with the recesses, and penetrate through the second level connector 120. The central mechanical preloading mechanism 170 penetrates through the first level connector 110 and the second level connector 120.

By excitation at an appropriate AC voltage, the second piezoelectric material columns 141 and the third piezoelectric material columns 151 extend (i.e., the set of second piezoelectric material columns 140 and the set of third piezoelectric material columns 150 extend), while the first piezoelectric material columns 131 are contracted (i.e., when the set of first piezoelectric material columns 130 is contracted); or the second piezoelectric material columns 141 and the third piezoelectric material columns 151 are contracted (i.e., the set of second piezoelectric material columns 140 and the set of third piezoelectric material columns 150 are contracted), while the first piezoelectric material columns 131 extend (i.e., when the set of first piezoelectric material columns 130 extends); and as a result, the axial displacements of the respective sets of material columns are superimposed on each other to achieve a greater axial displacement. And, since each of the number of the first piezoelectric material columns 131, the number of the second piezoelectric material columns 141, and the number of the third piezoelectric material columns 151 is three, the connection of the piezoelectric material columns with the first level connector 110 or the second level connector 120 will be more firm, and a failure of the piezoelectric actuator 100 caused by a vibration or shock load does not occur easily.

Referring to the schematic view shown in Fig. 7, as a schematic view, the displacement of each part is enlarged in Fig. 7, and in a practical case the displacement may not be so obvious, wherein the dashed lines at left and right sides serve as auxiliary lines to facilitate the observation of a change in displacement of each part.

The piezoelectric actuator 100 in an upper portion of Fig. 7 is in an unactivated state, and the piezoelectric actuator 100 in a lower portion of Fig. 7 is in an activated state. In both states, the position of the first level connector 110 is unchanged. The position of the first level connector 110 and the above-mentioned two auxiliary lines are used as a reference. When it is converted from the unactivated state to the activated state, the first piezoelectric material columns 131 are contracted and generate a displacement D1, the second piezoelectric material columns 141 extend and generate a displacement D2, and the third piezoelectric material columns 151 extend and generate a displacement D3. Compared to the piezoelectric actuator 100 in the unactivated state, the total displacement of the piezoelectric actuator 100 in the activated state is a sum of the displacements of the first piezoelectric material columns 131, the second piezoelectric material columns 141 and the third piezoelectric material columns 151, i.e., D1+D2+D3.

The first piezoelectric material columns 131, the second piezoelectric material columns 141, and the third piezoelectric material columns 151 may be all cylindrical piezoelectric material columns. Further, the respective cross sections of the piezoelectric material columns perpendicular to the axis line may be the same. The number of the first piezoelectric material columns 131, the number of the second piezoelectric material columns 141, and the number of the third piezoelectric material columns 151 may be adjusted according to different applications.

The cylindrical piezoelectric material columns may be each composed of a piezoelectric ceramic stack, wherein the piezoelectric ceramic includes lead zirconate titanate piezoelectric ceramic (piezoelectric ceramic transducer, PZT) and materials derived therefrom.

The first piezoelectric material columns 131, the second piezoelectric material columns 141, and the third piezoelectric material columns 151 each may also be constituted by a radially polarized piezoelectric ceramic tube, a single piezoelectric crystal or bonded piezoelectric single crystal active elements.

Further, the first level connector 110 and the second level connector 120 are made of a lightweight, high-strength metal or alloy, including, but not limited to, an aluminum alloy, a magnesium alloy, a titanium alloy, an aluminum beryllium alloy, and aluminum-based or magnesium-based composite. The simulation experiment showed that if the material of the first level connector 110 and the second level connector 120 is an aluminum alloy, and the first piezoelectric material columns 131, the second piezoelectric material columns 141, and the third piezoelectric material columns 151 are each made of a PZT piezoelectric ceramic stack, the bending displacement of the first level connector 110 and the second level connector 120 is about five percent of the total axial displacement of the piezoelectric actuator 100.

The first level connector 110 and the second level connector 120 are disc-shaped, have a certain thickness, and may be specifically approximated to a short cylindrical level connector. The short cylindrical structure contributes to ensuring the reliable connection of the above-mentioned piezoelectric material columns with the recesses, so that the first level connector 110 and the second level connector 120 are not easily bent or deformed in operation.

The central mechanical preloading mechanism 170 of the piezoelectric actuator 100 provided in the embodiment of the present invention is configured to apply compressive stress to the first set of piezoelectric material column 130, the second set of piezoelectric material column 140 and the third set of piezoelectric material column 150 so that the above-mentioned piezoelectric actuator 100 is operated under the action of the compressive stress.

Referring to Fig. 8 for details, Fig. 8 shows a low frequency underwater projector 200 provided in an embodiment of the present invention. The low frequency underwater projector 200 is driven by the piezoelectric actuator 100 as described above. The low frequency underwater projector 200 further comprises a front radiation head 210 and a tail mass 220, the second piezoelectric material columns 141 of the piezoelectric actuator 100 are connected with the front radiation head 210, the third piezoelectric material columns 151 of the piezoelectric actuator 100 are connected with the tail mass 220, and preload force is provided to the piezoelectric actuator 100 by the central mechanical preloading mechanism 170.

The resonant frequency of the low frequency underwater projector 200 as shown in Fig. 8 is the lowest value of the coupled resonance of the respective parts, i.e., the front radiation head 210, the first level connector 110, the second level connector 120, the first set of piezoelectric material column 130, the second set of piezoelectric material column 140, the third set of piezoelectric material column 150, the tail mass 220, and the central mechanical preloading mechanism 170 as a whole. The low frequency underwater projector 200 can effectively utilize the multimode coupled resonance to expand the operating frequency band.

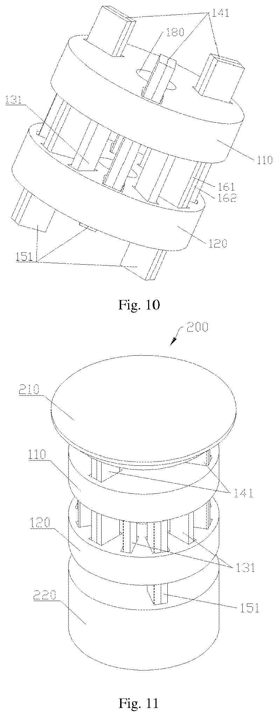

Referring to Fig. 10 for details, Fig. 10 shows a piezoelectric actuator 100 provided in another preferred embodiment of the present invention, and the piezoelectric actuator 100 shown in Fig. 10 is distinguished from the piezoelectric actuator 100 shown in Fig. 6 in that the first piezoelectric material columns 131, the second piezoelectric material columns 141, and the third piezoelectric material columns 151 of the piezoelectric actuator 100 shown in Fig. 10 are each of a rectangular parallelepiped structure, and the materials of the set of first piezoelectric material columns 130, the set of second piezoelectric material columns 140, and the set of third piezoelectric material columns 150 are lead-based relaxor ferroelectric single crystals.

Specifically, each of the rectangular parallelepiped material columns may comprise a first single crystal active element 161 and a second single crystal active element 162, the size of the first single crystal active element 161 is the same as that of the second single crystal active element 162, and the first crystal active element 161 and the second single crystal active element 162 are connected by bonding, referring to Fig. 10 for details.

The transverse piezoelectric properties of the lead-based relaxor ferroelectric single crystals are more excellent. The lead-based relaxor ferroelectric single crystals may specifically include Pb(Zn_{1/3}Nb_{2/3})O₃-PbTiO₃, Pb(Mg_{1/3}Nb_{2/3})O₃-PbTiO₃, Pb(In_{1/2}Nb_{1/2})O₃-Pb(Mg_{1/3}Nb_{2/3})O₃-PbTiO₃, Pb(Mg_{1/3}Nb_{2/3})O₃-Pb(Zr₀.₄₈Ti₀.₅₂)O₃, and materials derived therefrom.

Referring to Fig. 11 for details, Fig. 11 shows a low frequency underwater projector 200 driven by the piezoelectric actuator 100 shown in Fig. 10. The low frequency underwater projector 200 shown in Fig. 11 is distinguished from the low frequency underwater projector 200 shown in Fig. 8 in that the piezoelectric actuator 100 of the low frequency underwater projector 200 shown in Fig. 11 is different from the piezoelectric actuator 100 of the low frequency underwater projector 200 shown in Fig. 8. The center frequency of the same-size underwater projector made from PZN-5.5% PT d₃₂ transverse mode single crystal slices polarized in the [011] direction is 1/4 lower than that of one driven by PZT piezoelectric ceramic stacks.

It is possible to select conductive epoxy and nonconductive epoxy, as desired, to bond the first level connector 110 and the corresponding piezoelectric material columns, and bond the second level connector 120 and the corresponding piezoelectric material columns.

Further, the low frequency underwater projector 200 further comprises a first pre-stress mechanism. The first pre-stress mechanism is connected with the first level connector 110 and the second level connector 120, and the first pre-stress mechanism is configured to apply pre-stress to the first level connector 110 and the second level connector 120 so that the first piezoelectric material columns 131 are under predetermined compressive stress during operation.

Optionally, the first level connector 110 further comprises a central through hole located in the first level connector 110, and the second level connector 120 further comprises a central through hole located in the second level connector 120. The first pre-stress mechanism comprises a first stress rod, at least one first resilient member and at least one first locking member. Optionally, the resilient member is provided with at least one locking member. Both ends of the first stress rod pass through the central through holes corresponding to the first level connector 110 and the second level connector 120, respectively. When there is one first resilient member the first resilient member, between the first level connector 110 and the first locking member or between the second level connector 120 and the first locking member, are pressed by the first level connector 110 and the first locking member or by the second level connector 120 and the first locking member, when there are two first resilient members, one of the two first resilient members is located between and pressed by the first level connector 110 and one first locking member, and the other is located between and pressed by the second level connector and another first locking member. The first resilient member may be embodied as a spring washer or a disc spring. The first locking member may be embodied as a locking nut and be in threaded connection with the end of the first stress rod.

Further, the low frequency underwater projector 200 further comprises a second pre-stress mechanism, the second pre-stress mechanism is connected with the front radiation head 210 and the tail mass 220, and the second pre-stress mechanism is configured to apply pre-stress to the front radiation head 210 and the tail mass 220 so that the second piezoelectric material columns 141 and the third piezoelectric material columns 151 are under predetermined compressive stress during operation.

Optionally, the second pre-stress mechanism comprises a second stress rod and at least one second resilient member. The first stress rod has a central through hole running along its own length direction, and the second stress rod is movably embedded in the central through hole of the first stress rod and has both ends extending beyond the central through hole. At least one end of the second stress rod is connected with the front radiation head 210 and/or the tail mass 220 through the second resilient members, respectively, so as to apply predetermined compressive stress to the second piezoelectric material columns 141 and the third piezoelectric material columns 151 during operation. That is, when there is one second resilient member, one end of the second stress rod is connected with the front radiation head through the second resilient member, or one end of the second stress rod is connected with the tail mass through the second resilient member. When there are two second resilient members, two ends of the second stress rod are connected with the front radiation head and the tail mass through the two second resilient members.

The first pre-stress mechanism applies compressive stress F1 to the first piezoelectric material columns 131. The front radiation head 210 is connected with the second level connector 120 through the second piezoelectric material columns 141, and the tail mass 220 is connected with the first level connector 110 through the third piezoelectric material columns 151. Therefore, when the second pre-stress mechanism provides preset compressive stress F2 to the front radiation head 210 and the tail mass 220, the second pre-stress mechanism simultaneously applies tensile stress F2 (opposite to the direction of the compressive stress F1) to the first piezoelectric material columns 131 connected between the first level connector 110 and the second level connector 120.

Thus, optionally, the compressive stress applied by the first pre-stress mechanism is at least 2 times the compressive stress applied by the second pre-stress mechanism. This will ensure that the set of first piezoelectric material columns 130, the set of second piezoelectric material columns 140, the set of third piezoelectric material columns 150, and various related connections on the material columns of the embodiment of the present invention are always operated under predetermined compressive stress. The second resilient member may be a combination of a spring washer and a locking structure.

It should be noted that the first pre-stress mechanism and the second pre-stress mechanism may be of other structures. For example, a set of first stress rods (equipped with suitable spring washers and locking structures) are disposed, and the set of first stress rods are arranged uniformly along the circumferential directions of the first level connector 110 and the second level connector 120, so as to apply a pre-pressure to the first level connector 110, the second level connector 120, and the first piezoelectric material columns 131.

Optionally, an anti-bending guide means is further comprised, and the guide means and the piezoelectric actuator 100 are movably connected in the direction of extending and contraction of the piezoelectric actuator 100 and connected in a direction perpendicular to the extending and contraction direction.

Further, a housing may be added, which has an inner cavity, and the piezoelectric actuator 100 is disposed in the inner cavity of the housing so that the housing protects the various components of the piezoelectric actuator 100.

The piezoelectric actuator 100 and the low frequency underwater projector 200 provided in the embodiments of the present invention comprise a first level connector 110, a second level connector 120 and a set of first piezoelectric material columns 130. One ends of the first piezoelectric material columns 131 are matched with a set of first recesses 111 located in the first level connector 110, and the other ends of the first piezoelectric material columns 131 are matched with a set of second recesses 121 located in the second level connector 120. The first piezoelectric material columns 131 are contracted or extend to drive the displacement of the first level connector 110 and the second level connector 120. Moreover, the displacements of the second piezoelectric material columns 141 and the third piezoelectric material columns 151 is superimposed with the displacements of the first level connector 110 and the second level connector 120.

The axial displacements of the piezoelectric materials can be superimposed and increased by excitation at an appropriate AC voltage, thus the sound power capacity of the low frequency underwater projector 200 using the piezoelectric actuator 100 as a driving mechanism is increased. The piezoelectric actuator 100 and the low frequency underwater projector 200 provided in the embodiments of the present invention improve the problem of the limited sound power capacity of the existing low frequency underwater projectors 200.

In order to make the objects, technical solutions and advantages of the embodiments of the present invention more clear, the technical solutions of the embodiments of the present invention have been described above clearly and completely with reference to the drawings of the embodiments of the present invention.

It should be noted that similar reference numerals and letters refer to similar items in the following figures, and thus once an item is defined in one figure, it may not be further defined or explained in the following figures.

Industrial Applicability: in use of the piezoelectric actuator 100 and the low frequency underwater projector 200 of the present invention obtained by the above-mentioned design, the axial displacements of the piezoelectric materials can be superimposed and increased by excitation at an appropriate voltage, and thus the sound power capacity of the low frequency underwater projector 200 using the piezoelectric actuator 100 as a driving mechanism is increased. The piezoelectric actuator 100 and the low frequency underwater projector 200 of the present invention obtained by the above-mentioned design can improve the problem of the limited sound power capacity of the existing low frequency underwater projectors 200 and are suitable for widespread use in industries.

## Claims

1. A piezoelectric actuator (100), comprising a first level connector (110), a second level connector (120) disposed opposite to the first level connector (110), a set of first piezoelectric material columns (131), a set of second piezoelectric material columns (141), and a set of third piezoelectric material columns (151),
**characterized in that** the first level connector (110) and the second level connector (120) are both disc-shaped and of a certain thickness such that they are not deformed in operation;
wherein the numbers of piezoelectric material columns in the first, second and third sets of piezoelectric material columns (131, 141, 151) are the same, each set has three piezoelectric material columns;
wherein the three first piezoelectric material columns (131) are spaced at equal angular separation along a circumferential line of the first and second level connectors (110, 120) and both ends of each of the first piezoelectric material columns (131) are connected with the first level connector (110) and the second level connector (120), respectively;
wherein the three second piezoelectric material columns (141) are spaced at equal angular separation along a circumferential line of the first and second level connectors (110, 120) and each of the second piezoelectric material columns (141) has one end connected with the second level connector (120) and the other end passes through 3 equally spaced through holes in the first level connector (110) in a direction away from the second level connector (120) so that the three second piezoelectric material columns (141) and the second level connector (120) are able to displace relative to the first level connector (110);
wherein the three third piezoelectric material columns (151) are spaced at equal angular separation along a circumferential line of the first and second level connectors (110, 120) and each of the third piezoelectric material columns (151) has one end connected with the first level connector (110) and the other end passes through 3 equally spaced holes in the second level connector (120) in a direction away from the first level connector (110) so that the three third piezoelectric material columns (151) and the first level connector (110) are able to displace relative to the second level connector (120);
wherein during operation, the first piezoelectric material columns (131) contract while the second and third piezoelectric material columns (141, 151) extend, or vice versa, so that the axial displacements of the three sets of piezoelectric material columns add up to produce the larger overall displacement of the actuator,
wherein recesses are provided on opposite surfaces of the first level connector (110) and the second level connector (120) at locations where the first, second and third piezoelectric material columns (131, 141, 151) are connected and the first, second and third piezoelectric material columns (131, 141, 151) are bonded into the corresponding recesses.

2. The piezoelectric actuator (100) according to claim 1, wherein the first, second and third piezoelectric material columns (131, 141, 151) are each a piezoceramic stack of a suitable cross-section, a piezoceramic of rectangular or parallelepiped shape, or a radially polarized piezoceramic tube, wherein the piezoceramics include lead zirconate titanate [Pb(ZrₓTi₁₋ₓ)O₃] piezoceramics and materials derived therefrom.

3. The piezoelectric actuator (100) according to claim 1, wherein the first, second and third piezoelectric material columns (131, 141, 151) are each a rectangular shaped piezoelectric single crystal or bonded piezoelectric single crystals comprising Pb(Zn_{1/3}Nb_{2/3})O₃-PbTiO₃, Pb(Mg_{1/3}Nb_{2/3})O₃-PbTiO₃, Pb(In_{1/2}Nb_{1/2})O₃-Pb(Mg_{1/3}Nb_{2/3})O₃-PbTiO₃, Pb(Mg_{1/3}Nb_{2/3})O₃-Pb(Zr₀.₄₈Ti₀.₅₂)O₃, and materials derived therefrom.

4. The piezoelectric actuator (100) according to any one of claims 1 to 3, wherein the first and second level connectors (110, 120) further comprise a central through hole (180) respectively.

5. The piezoelectric actuator (100) according to any one of claims 1 to 4, wherein the first level connector (110) and the second level connector (120) are made of a lightweight, high-strength metal or alloy, including but not limited to, an aluminum alloy, a magnesium alloy, a titanium alloy, an aluminum beryllium alloy, and aluminum-based or magnesium-based composite.

6. The piezoelectric actuator (100) according to any one of claims 1 to 5, wherein the number of first piezoelectric material columns (131), the number of second piezoelectric material columns (141), and the number of third piezoelectric material columns (151) are adjustable and the number of through holes and recesses in the first level connector (110) and the second level connector (120) are adjusted correspondingly.

7. The piezoelectric actuator (100) according to claim 4 further comprising a first pre-stress mechanism which includes a first stress rod which passes through the central through holes (180) in the first level connector (110) and the second level connector (120), at least one first resilient member and at least one first locking member, such that the first pre-stress mechanism applies a compressive force to the first level connector (110) and the second level connector (120) to place the first piezoelectric material columns (131) under predetermined compressive stress during operation.

8. The piezoelectric actuator (100) according to any one of claims 1 to 7 further comprising a housing, wherein the housing has an inner cavity and the piezoelectric actuator (100) is disposed in the inner cavity of the housing so that the housing protects the various components of the piezoelectric actuator (100).

9. A low frequency underwater projector (200), **characterized in that** the low frequency underwater projector (200) comprises a piezoelectric actuator (100) as claimed in any one of claims 1 to 8 and further comprises a front radiation head (210) and a tail mass (220), wherein the free ends of the second piezoelectric material columns (141) are connected with the front radiation head (210), and the free ends of the third piezoelectric material columns (151) are connected with the tail mass (220).

10. The low frequency underwater projector (200) according to claim 9, further comprising a second pre-stress mechanism which includes a second stress rod, at least one second resilient member and at least one second locking member, wherein the second pre-stress mechanism serves to place the second and third piezoelectric material columns under compression during operation;
wherein, preferably, the first stress rod of the first pre-stress mechanism of the underwater projector has a central through hole such that the second stress rod passes through the central through hole in the first stress rod; wherein one end of the second stress rod is connected to the front radiation head (210) and the other end to the tail mass (220) through the second resilient member to enable the application of compressive stress onto the second and the third piezoelectric material columns (141, 151);
wherein, alternatively, the first pre-stress mechanism of the underwater projector comprises a set of stress rods, suitable spring washers and locking structures, and the set of the first stress rods are arranged uniformly along a circumferential length of the first level connector (110) and the second level connector (120) to enable the application of compressive stress onto the first piezoelectric material columns (131), wherein one end of the second stress rod is connected to the front radiation head (210) and the other end to the tail mass (220) through the second resilient member to enable the application of compressive stress onto the second and the third piezoelectric material columns (141, 151);
wherein the compressive force exerted by the first pre-stress mechanism is larger than that exerted by the second pre-stress mechanism, so that the first, second and third piezoelectric material columns are all placed under compression during operation.

11. The low frequency underwater projector (200) according to any one of claims 9 and 10, further comprising an anti-bending guide means which allows the piezoelectric actuator (100) to move freely in its axial direction but with restricted side-way movement.

## Patentansprüche

1. Piezoelektrischer Aktuator (100), umfassend einen Verbinder der ersten Ebene (110), einen Verbinder der zweiten Ebene (120), der gegenüber dem Verbinder der ersten Ebene (110) angeordnet ist, einen Satz von ersten Säulen aus piezoelektrischem Material (131), einen Satz von zweiten Säulen aus piezoelektrischem Material (141), und einen Satz von dritten Säulen aus piezoelektrischem Material (151),
**dadurch gekennzeichnet, dass** der Verbinder der ersten Ebene (110) und der Verbinder der zweiten Ebene (120) beide scheibenförmig und von einer bestimmten Dicke sind, so dass sie im Betrieb nicht verformt sind;
wobei die Anzahl der Säulen aus piezoelektrischem Material in dem ersten, zweiten und dritten Satz von Säulen aus piezoelektrischem Material (131, 141, 151) gleich ist, wobei jeder Satz drei Säulen aus piezoelektrischem Material aufweist;
wobei die drei ersten Säulen aus piezoelektrischem Material (131) in gleichem Winkelabstand entlang einer Umfangslinie der Verbinder der ersten und zweiten Ebene (110, 120) beabstandet sind, und beide Enden jeder der ersten Säulen aus piezoelektrischem Material (131) mit dem Verbinder der ersten Ebene (110) bzw. dem Verbinder der zweiten Ebene (120) verbunden sind;
wobei die drei zweiten Säulen aus piezoelektrischem Material (141) in gleichem Winkelabstand entlang einer Umfangslinie der Verbinder der ersten und zweiten Ebene (110, 120) beabstandet sind, und jede der zweiten Säulen aus piezoelektrischem Material (141) ein Ende aufweist, das mit dem Verbinder der zweiten Ebene (120) verbunden ist, und das andere Ende durch 3 gleichmäßig beabstandete Löcher im Verbinder der ersten Ebene (110) in einer Richtung weg vom Verbinder der zweiten Ebene (120) verläuft, so dass die drei zweiten Säulen aus piezoelektrischem Material (141) und der Verbinder der zweiten Ebene (120) in der Lage sind, relativ zum Verbinder der ersten Ebene (110) zu verschieben;
wobei die drei dritten Säulen aus piezoelektrischem Material (151) in gleichem Winkelabstand entlang einer Umfangslinie der Verbinder der ersten und zweiten Ebene (110, 120) beabstandet sind, und jede der dritten Säulen aus piezoelektrischem Material (151) ein Ende aufweist, das mit dem Verbinder der ersten Ebene (110) verbunden ist, und das andere Ende durch 3 gleichmäßig beabstandete Löcher im Verbinder der zweiten Ebene (120) in einer Richtung weg vom Verbinder der ersten Ebene (110) verläuft, so dass die drei dritten Säulen aus piezoelektrischem Material (151) und der Verbinder der ersten Ebene (110) in der Lage sind, relativ zum Verbinder der zweiten Ebene (120) zu verschieben;
wobei sich während des Betriebs die ersten Säulen aus piezoelektrischem Material (131) zusammenziehen, während sich die zweiten und dritten Säulen aus piezoelektrischem Material (141, 151) ausdehnen, oder umgekehrt, so dass sich die axialen Verschiebungen der drei Sätze von Säulen aus piezoelektrischem Material addieren, um die größere Gesamtverschiebung des Aktuators zu erzeugen,
wobei Aussparungen an gegenüberliegenden Oberflächen des Verbinders der ersten Ebene (110) und des Verbinders der zweiten Ebene (120) an Stellen vorgesehen sind, an denen die ersten, zweiten und dritten Säulen aus piezoelektrischem Material (131, 141, 151) verbunden sind, und die ersten, zweiten und dritten Säulen aus piezoelektrischem Material (131, 141, 151) in die entsprechenden Aussparungen eingeklebt sind.

2. Piezoelektrischer Aktuator (100) nach Anspruch 1, wobei die ersten, zweiten und dritten Säulen aus piezoelektrischem Material (131, 141, 151) jeweils ein piezokeramischer Stapel mit geeignetem Querschnitt, eine Piezokeramik mit rechteckiger oder parallelepipedischer Form sind, oder eine radial polarisierte piezokeramische Röhre, wobei die Piezokeramiken Bleizirkonat-Titanat [Pb(Zr_{×}Ti₁₋ₓ)O₃;] Piezokeramiken und davon abgeleitete Materialien umfassen.

3. Piezoelektrischer Aktuator (100) nach Anspruch 1, wobei die ersten, zweiten und dritten Säulen aus piezoelektrischem Material (131, 141, 151) jeweils ein rechteckig geformtes piezoelektrisches Einkristall oder gebundene piezoelektrische Einkristalle sind, die Pb(Zn_{1/3}Nb_{2/3})O₃-PbTiO₃, Pb(Mg_{1/3}Nb_{2/3})O₃-PbTiO₃, Pb(In_{1/2}Nb_{1/2})O₃-Pb(Mg_{1/3}Nb_{2/3})O₃-PbTiO₃, Pb(Mg_{1/3}Nb_{2/3})O₃-Pb (Zr₀,₄₈Ti₀,₅₂)O₃ umfassen, und davon abgeleitete Materialien.

4. Piezoelektrischer Aktuator (100) nach einem der Ansprüche 1 bis 3, wobei die Verbinder der ersten und zweiten Ebene (110, 120) ferner jeweils ein zentrales Durchgangsloch (180) umfassen.

5. Piezoelektrischer Aktuator (100) nach einem der Ansprüche 1 bis 4, wobei der Verbinder der ersten Ebene (110) und der Verbinder der zweiten Ebene (120) aus einem leichten, hochfesten Metall oder einer Legierung hergestellt sind, einschließlich, aber nicht beschränkt auf eine Aluminiumlegierung, eine Magnesiumlegierung, eine Titanlegierung, eine Aluminium-Beryllium-Legierung und ein Verbundwerkstoff auf Aluminium- oder Magnesiumbasis.

6. Piezoelektrischer Aktuator (100) nach einem der Ansprüche 1 bis 5, wobei die Anzahl der ersten Säulen aus piezoelektrischem Material (131), die Anzahl der zweiten Säulen aus piezoelektrischem Material (141) und die Anzahl der dritten Säulen aus piezoelektrischem Material (151) einstellbar sind, und die Anzahl der Durchgangslöcher und Aussparungen im Verbinder der ersten Ebene (110) und im Verbinder der zweiten Ebene (120) entsprechend eingestellt wird.

7. Piezoelektrischer Aktuator (100) nach Anspruch 4, ferner umfassend einen ersten Vorspannungsmechanismus, der einen ersten Spannstab umfasst, der durch die zentralen Durchgangslöcher (180) in dem Verbinder der ersten Ebene (110) und dem Verbinder der zweiten Ebene (120) verläuft, mindestens ein erstes elastisches Element und mindestens ein erstes Verriegelungselement, so dass der erste Vorspannungsmechanismus eine Druckkraft auf den Verbinder der ersten Ebene (110) und den Verbinder der zweiten Ebene (120) ausübt, um die ersten Säulen aus piezoelektrischem Material (131) unter vorbestimmter Druckspannung während des Betriebs zu platzieren.

8. Piezoelektrischer Aktuator (100) nach einem der Ansprüche 1 bis 7, ferner umfassend ein Gehäuse, wobei das Gehäuse einen inneren Hohlraum aufweist, und der piezoelektrische Aktuator (100) in dem inneren Hohlraum des Gehäuses angeordnet ist, so dass das Gehäuse die verschiedenen Komponenten des Piezoelektrischer Aktuators (100) schützt.

9. Niederfrequenz-Unterwasserprojektor (200), **dadurch gekennzeichnet, dass** der Niederfrequenz-Unterwasserprojektor (200) einen piezoelektrischen Aktuator (100) nach einem der Ansprüche 1 bis 8 umfasst, und ferner einen vorderen Strahlungskopf (210) und eine Schwanzmasse (220) umfasst, wobei die freien Enden der zweiten Säulen aus piezoelektrischem Material (141) mit dem vorderen Strahlungskopf (210) verbunden sind, und die freien Enden der dritten Säulen aus piezoelektrischem Material (151) mit der Schwanzmasse (220) verbunden sind.

10. Niederfrequenz-Unterwasserprojektor (200) nach Anspruch 9, ferner umfassend einen zweiten Vorspannungsmechanismus, der einen zweiten Spannstab, mindestens ein zweites elastisches Element und mindestens ein zweites Verriegelungselement umfasst, wobei der zweite Vorspannungsmechanismus dazu dient, die zweiten und dritten Säulen aus piezoelektrischem Material während des Betriebs unter Druck zu setzen;
wobei vorzugsweise der erste Spannstab des ersten Vorspannungsmechanismus des Unterwasserprojektors ein zentrales Durchgangsloch aufweist, so dass der zweite Spannstab durch das zentrale Durchgangsloch in dem ersten Spannstab verläuft; wobei ein Ende des zweiten Spannstabs mit dem vorderen Strahlungskopf (210) und dem anderen Ende mit der Schwanzmasse (220) durch das zweite elastische Element verbunden ist, um das Aufbringen einer Druckspannung auf die zweiten und dritten Säulen aus piezoelektrischem Material (141, 151) zu ermöglichen;
wobei alternativ der erste Vorspannungsmechanismus des Unterwasserprojektors einen Satz von Spannstäben, geeignete Federringe und Verriegelungsstrukturen umfasst, und der Satz der ersten Spannungsstäbe gleichmäßig entlang einer Umfangslänge des Verbinders der ersten Ebene (110) und des Verbinders der zweiten Ebene (120) angeordnet ist, um das Aufbringen von Druckspannung auf die ersten Säulen aus piezoelektrischem Material(131) zu ermöglichen, wobei ein Ende des zweiten Spannstabs mit dem vorderen Strahlungskopf (210) und das andere Ende mit der Schwanzmasse (220) durch das zweite elastische Element verbunden ist, um das Aufbringen einer Druckspannung auf die zweiten und dritten Säulen aus piezoelektrischem Material zu ermöglichen (141, 151);
wobei die durch den ersten Vorspannungsmechanismus ausgeübte Druckkraft größer ist als die durch den zweiten Vorspannungsmechanismus ausgeübte, so dass die ersten, zweiten und dritten Säulen aus piezoelektrischem Material während des Betriebs alle unter Druck gesetzt werden.

11. Niederfrequenz-Unterwasserprojektor (200) nach einem der Ansprüche 9 und 10, ferner umfassend eine Anti-Biege-Führungseinrichtung, die es dem piezoelektrischen Aktuator (100) ermöglicht, sich frei in seiner axialen Richtung, jedoch mit eingeschränkter Seitwärtsbewegung zu bewegen.

## Revendications

1. Actionneur piézoélectrique (100), comprenant un connecteur de premier niveau (110), un connecteur de second niveau (120) disposé à l'opposé du connecteur de premier niveau (110), un ensemble de premières colonnes de matériau piézoélectrique (131), un ensemble de deuxièmes colonnes de matériau piézoélectrique (141) et un ensemble de troisièmes colonnes de matériau piézoélectrique (151),
**caractérisé en ce que** le connecteur de premier niveau (110) et le connecteur de second niveau (120) sont tous deux en forme de disque et d'une certaine épaisseur telle qu'ils sont pas déformés en fonctionnement;
où les nombres de colonnes de matériau piézoélectrique dans les premier, deuxième et troisième ensembles de colonnes de matériau piézoélectrique (131, 141, 151) sont identiques, chaque ensemble a trois colonnes de matériau piézoélectrique;
où les trois premières colonnes de matériau piézoélectrique (131) sont espacées à une séparation angulaire égale le long d'une ligne circonférentielle des connecteurs de premier et second niveau (110, 120) et les deux extrémités de chacune des premières colonnes de matériau piézoélectrique (131) sont reliées au connecteur de premier niveau (110) et au connecteur de second niveau (120), respectivement;
où les trois deuxièmes colonnes de matériau piézoélectrique (141) sont espacées à une séparation angulaire égale le long d'une ligne circonférentielle des connecteurs de premier et second niveau (110, 120) et chacune des deuxièmes colonnes de matériau piézoélectrique (141) a une extrémité connectée au connecteur de second niveau (120) et l'autre extrémité passe à travers 3 trous traversants également espacés dans le connecteur de premier niveau (110) dans une direction s'éloignant du connecteur de second niveau (120) de sorte que les trois deuxièmes colonnes de matériau piézoélectrique (141) et le connecteur de second niveau (120) peuvent se déplacer par rapport au connecteur de premier niveau (110);
où les trois troisièmes colonnes de matériau piézoélectrique (151) sont espacées à une séparation angulaire égale le long d'une ligne circonférentielle des connecteurs de premier et second niveau (110, 120) et chacune des troisièmes colonnes de matériau piézoélectrique (151) a une extrémité connectée au connecteur de premier niveau (110) et l'autre extrémité passe à travers 3 trous également espacés dans le connecteur de second niveau (120) dans une direction s'éloignant du connecteur de premier niveau (110) de sorte que les trois troisièmes colonnes de matériau piézoélectrique (151) et le connecteur de premier niveau (110) peuvent se déplacer par rapport au connecteur de second niveau (120);
où pendant le fonctionnement, les premières colonnes de matériau piézoélectrique (131) se contractent tandis que les deuxièmes et troisièmes colonnes de matériau piézoélectrique (141, 151) s'étendent, ou vice versa, de sorte que les déplacements axiaux des trois ensembles de colonnes de matériau piézoélectrique s'additionnent pour produire un déplacement global plus grand de l'actionneur,
où des évidements sont prévus sur des surfaces opposées du connecteur de premier niveau (110) et du connecteur de second niveau (120) aux emplacements où les premières, deuxièmes et troisièmes colonnes de matériau piézoélectrique (131, 141, 151) sont connectées et les premières, deuxièmes et troisièmes colonnes de matériau piézoélectrique (131, 141, 151) sont liées dans les évidements correspondants.

2. Actionneur piézoélectrique (100) selon la revendication 1, dans lequel les premières, deuxièmes et troisièmes colonnes de matériau piézoélectrique (131, 141, 151) sont chacune un empilement piézocéramique d'une section transversale appropriée, une piézocéramique de forme rectangulaire ou parallélépipédique, ou un tube piézocéramique polarisé radialement, où les piézocéramiques comprennent les piézocéramiques de titanate de zirconate de plomb [Pb(Zr_{×}Ti₁₋ₓ)O₃] et les matériaux qui en sont dérivés.

3. Actionneur piézoélectrique (100) selon la revendication 1, dans lequel les premières, deuxièmes et troisièmes colonnes de matériau piézoélectrique (131, 141, 151) sont chacune un monocristal piézoélectrique de forme rectangulaire ou des monocristaux piézoélectriques liés comprenant du Pb(Zn₁/₃Nb_{2/3})O₃-PbTiO₃, Pb(Mg_{1/3}Nb_{2/3})O₃-PbTiO₃, Pb(In_{1/2}Nb_{1/2})O₃-Pb(Mg_{1/3}Nb_{2/3})O₃-PbTiO₃, Pb(Mg_{1/3}Nb_{2/3})O₃-Pb (Zr₀,₄₈Ti₀,₅₂)O₃, et les matériaux qui en dérivent.

4. Actionneur piézoélectrique (100) selon l'une quelconque des revendications 1 à 3, dans lequel les connecteurs de premier et second niveau (110, 120) comprennent en outre un trou central traversant (180) respectivement.

5. Actionneur piézoélectrique (100) selon l'une quelconque des revendications 1 à 4, dans lequel le connecteur de premier niveau (110) et le connecteur de second niveau (120) sont constitués d'un métal ou d'un alliage léger, à haute résistance, comprenant, mais sans s'y limiter, un alliage d'aluminium, un alliage de magnésium, un alliage de titane, un alliage d'aluminium-béryllium, et un composite à base d'aluminium ou à base de magnésium.

6. Actionneur piézoélectrique (100) selon l'une quelconque des revendications 1 à 5, dans lequel le nombre de premières colonnes de matériau piézoélectrique (131), le nombre de deuxièmes colonnes de matériau piézoélectrique (141) et le nombre de troisièmes colonnes de matériau piézoélectrique (151) sont réglables et le nombre de trous traversants et d'évidements dans le connecteur de premier niveau (110) et le connecteur de second niveau (120) est ajusté en conséquence.

7. Actionneur piézoélectrique (100) selon la revendication 4, comprenant en outre un premier mécanisme de précontrainte qui comprend une première tige de contrainte qui passe à travers les trous traversants centraux (180) dans le connecteur de premier niveau (110) et le connecteur de second niveau (120), au moins un premier élément résilient et au moins un premier élément de verrouillage, de sorte que le premier mécanisme de précontrainte applique une force de compression sur le connecteur de premier niveau (110) et le connecteur de second niveau (120) pour placer les premières colonnes de matériau piézoélectrique (131) sous une contrainte de compression prédéterminée pendant le fonctionnement.

8. Actionneur piézoélectrique (100) selon l'une quelconque des revendications 1 à 7 comprenant en outre un boîtier, dans lequel le boîtier a une cavité interne et l'actionneur piézoélectrique (100) est disposé dans la cavité interne du boîtier de sorte que le boîtier protège les différents composants de l'actionneur piézoélectrique (100).

9. Projecteur sous-marin basse fréquence (200), **caractérisé en ce que** le projecteur sous-marin basse fréquence (200) comprend un actionneur piézoélectrique (100) selon l'une quelconque des revendications 1 à 8 et comprend en outre une tête de rayonnement avant (210) et une masse de queue (220), où les extrémités libres des deuxièmes colonnes de matériau piézoélectrique (141) sont connectées à la tête de rayonnement avant (210), et les extrémités libres des troisièmes colonnes de matériau piézoélectrique (151) sont connectées à la masse de queue (220).

10. Projecteur sous-marin basse fréquence (200) selon la revendication 9, comprenant en outre un second mécanisme de précontrainte qui comprend une seconde tige de contrainte, au moins un second élément résilient et au moins un second élément de verrouillage, où le second mécanisme de précontrainte sert pour placer les deuxièmes et troisièmes colonnes de matériau piézoélectrique sous compression pendant le fonctionnement;
où, de préférence, la première tige de contrainte du premier mécanisme de précontrainte du projecteur sous-marin a un trou traversant central de sorte que la seconde tige de contrainte passe à travers le trou traversant central dans la première tige de contrainte; où une extrémité de la seconde tige de contrainte est connectée à la tête de rayonnement avant (210) et l'autre extrémité à la masse de queue (220) par le second élément résilient pour permettre l'application d'une contrainte de compression sur les deuxièmes et troisièmes colonnes de matériau piézoélectrique (141, 151) ;
où, en variante, le premier mécanisme de précontrainte du projecteur sous-marin comprend un ensemble de tiges de contrainte, des rondelles élastiques appropriées et des structures de verrouillage, et l'ensemble des premières tiges de contrainte est disposé uniformément le long d'une longueur circonférentielle du connecteur de premier niveau (110) et du connecteur de second niveau (120) pour permettre l'application d'une contrainte de compression sur les premières colonnes de matériau piézoélectrique (131), où une extrémité de la seconde tige de contrainte est connectée à la tête de rayonnement avant (210) et l'autre extrémité à la masse de queue (220) à travers le second élément résilient pour permettre l'application d'une contrainte de compression sur les deuxièmes et troisièmes colonnes de matériau piézoélectrique (141, 151);
où la force de compression exercée par le premier mécanisme de précontrainte est plus grande que celle exercée par le second mécanisme de précontrainte, de sorte que les premières, deuxièmes et troisièmes colonnes en matériau piézoélectrique sont toutes placées sous compression pendant le fonctionnement.

11. Projecteur sous-marin basse fréquence (200) selon l'une quelconque des revendications 9 et 10, comprenant en outre un moyen de guidage anti-flexion qui permet à l'actionneur piézoélectrique (100) de se déplacer librement dans sa direction axiale mais avec un mouvement latéral limité.
